# EUROPEAN PATENT APPLICATION

(11) **EP 4 654 764 A1**
(43) Date of publication of application: **26.11.2025**
(21) Application number: 24858159.7
(22) Date of filing: 24.07.2024
(51) Int. Cl.: H05K 5/02

(54) **INTEGRATED ASSEMBLY, MOTOR CONTROLLER AND POWERTRAIN**

(30) Priority: 31.08.2023 CN 202311134498
(71) Applicant: Huawei Digital Power Technologies Co., Ltd., Shenzhen, Guangdong 518043 (CN)
(72) Inventor: XU, Yankun, Shenzhen, Guangdong 518043 (CN); YU, Kang, Shenzhen, Guangdong 518043 (CN)
(74) Representative: Gill Jennings & Every LLP
(86) International application number: PCT/CN2024/107345
(87) International publication number: WO 2025/044616

(57) **Abstract**

Embodiments of this application provide an integrated component, a motor controller, and a powertrain. The integrated component includes an integrated housing and a capacitor core. The integrated housing is configured to accommodate the capacitor core. The integrated housing includes a first surface and a second surface that are opposite to each other in a first direction. The first surface includes two rows of fastening columns and two rows of supporting columns. Each row of the fastening columns includes a plurality of fastening columns, and each row of the supporting columns includes a plurality of supporting columns. In a second direction, the plurality of fastening columns in each row of the fastening columns are arranged at intervals, and the plurality of supporting columns in each row of the supporting columns are arranged at intervals. In a third direction, the two rows of supporting columns are arranged at an interval, and the two rows of fastening columns are arranged between the two rows of supporting columns at an interval. The integrated component provided in this application has high integration and high compactness, and can reduce components and parts of the motor controller, so that a size of the motor controller is reduced.

## Description

### CROSS-REFERENCE TO RELATED APPLICATIONS

This application claims priority to Chinese Patent Application No. 202311134498.6, filed with the China National Intellectual Property Administration on August 31, 2023 and entitled "INTEGRATED COMPONENT, MOTOR CONTROLLER, AND POWERTRAIN", which is incorporated herein by reference in its entirety.

### TECHNICAL FIELD

This application relates to the field of motor controller technologies, and in particular, to an integrated component, a motor controller, and a powertrain.

### BACKGROUND

Currently, electric vehicles represented by battery electric vehicles and hybrid electric vehicles are increasingly popular with consumers, and interior space and comfort of the electric vehicles also continuously increase. A motor controller in an electric vehicle is configured to convert a direct current provided by a power battery into an alternating current to supply power to a drive motor, thereby driving wheels of the electric vehicle by using the drive motor.

However, there are a large quantity of parts in the motor controller, and integration is low. As a result, an assembly process of the motor controller is complex, a gap between the parts in the motor controller is large, and compactness is poor. Consequently, a size of the motor controller is large.

### SUMMARY

Embodiments of this application provide an integrated component, a motor controller, and a powertrain. The integrated component is used in the motor controller. The integrated component has high integration and high compactness, and can reduce components and parts of the motor controller, so that a size of the motor controller is reduced.

According to a first aspect, this application provides an integrated component. The integrated component includes an integrated housing and a capacitor core. The integrated housing is configured to accommodate the capacitor core. The integrated housing includes a first surface and a second surface that are opposite to each other in a first direction. The first surface of the integrated housing includes two rows of fastening columns and two rows of supporting columns. In a second direction, each row of the fastening columns includes a plurality of fastening columns arranged at intervals in the second direction, and each row of the supporting columns includes a plurality of supporting columns arranged at intervals. In a third direction, the two rows of supporting columns are arranged at an interval, and the two rows of fastening columns are arranged between the two rows of supporting columns. In this embodiment, the supporting columns and the fastening columns are arranged on a same side of the integrated housing, and the two rows of fastening columns are arranged between the two rows of supporting columns. This can improve layout compactness of the integrated housing and reduce a size of the integrated housing. The two rows of supporting columns are configured to fasten a circuit board, and the two rows of fastening columns are configured to fasten a liquid cooling heat sink. The liquid cooling heat sink and the circuit board are respectively fastened to the integrated housing by using the supporting columns and the fastening columns, thereby improving integration of the integrated housing. When the integrated component is used in a motor controller, the motor controller includes fewer components and parts. This facilitates miniaturization of the motor controller.

In an embodiment, the first surface of the integrated housing includes a row of Hall magnetic cores. The row of Hall magnetic cores includes a plurality of Hall magnetic cores. The integrated housing integrates the Hall magnetic cores. This improves the integration of the integrated housing and compactness of the motor controller, and facilitates the miniaturization of the motor controller. In the second direction, the plurality of Hall magnetic cores are arranged at intervals, and each Hall magnetic core is arranged between two supporting columns. This can prevent interference between a power module and the supporting column when the power module is mounted on the integrated housing.

In an embodiment, the first surface of the integrated housing includes a plurality of mounting grooves. The plurality of mounting grooves are arranged at intervals in the second direction, and each mounting groove is configured to mount one Hall magnetic core. The integrated housing includes the mounting grooves for ease of mounting the Hall magnetic cores.

In an embodiment, the integrated component includes a plurality of copper bar connecting pieces. Each copper bar connecting piece is generally configured to electrically connect to one power module. Each Hall magnetic core includes a magnetic core through hole, and each magnetic core through hole is configured to allow one copper bar connecting piece to pass through in the third direction. In the first direction and the second direction, there is a gap between the copper bar connecting piece and an inner wall of the magnetic core through hole, to ensure that an alternating current can stably flow through the Hall magnetic core.

In an embodiment, the second surface of the integrated housing includes a filter cavity. The filter cavity is configured to accommodate a filter, and an orientation of an opening of the filter cavity is in the first direction. The filter is configured to electrically connect to the capacitor core, and the opening of the filter cavity is on the second surface, so that utilization of mounting space of the integrated housing is higher.

According to a second aspect, this application provides a motor controller. The motor controller includes a plurality of power modules, a liquid cooling heat sink, and the integrated component in any technical solution in the first aspect. Each power module includes at least one power transistor. Each power transistor is electrically connected to a capacitor core, and an integrated housing includes two coolant through holes. Each power transistor is electrically connected to a capacitor core, and an integrated housing includes two coolant through holes. In a first direction, the two coolant through holes separately run through the integrated housing. In a second direction, the two coolant through holes are arranged at an interval, to facilitate a connection between the coolant through holes and the liquid cooling heat sink. Both the two coolant through holes pass through the integrated housing. When a coolant passes through the two coolant through holes, the two coolant through holes may dissipate heat for the capacitor core, so that the integrated housing has a heat dissipation function. This improves compactness of the motor controller.

In an embodiment, the liquid cooling heat sink and the integrated housing are arranged in a stacked manner in the first direction. This can reduce a size of the motor controller in the first direction. In the second direction, a spacing between the two coolant through holes is less than a length of the liquid cooling heat sink. It may be ensured that the coolant in the coolant through holes does not need to be transferred to another pipeline or device in a process of being transported to the liquid cooling heat sink. This makes the motor controller more compact, and facilitates miniaturization of the motor controller. In a third direction, a diameter of each coolant through hole is less than a width of the liquid cooling heat sink. It may be ensured that the coolant in the coolant through holes does not need to be transferred to another pipeline or device in a process of being transported to the liquid cooling heat sink. This makes the motor controller more compact, and facilitates miniaturization of the motor controller.

In an embodiment, the power module further includes a plurality of direct current power input terminals, and each direct current power input terminal is configured to electrically connect to one power transistor and the capacitor core. The plurality of direct current power input terminals are sequentially arranged along one side of the liquid cooling heat sink. The direct current power input terminal facilitates an electrical connection between the power transistor and the capacitor core.

In an embodiment, the motor controller includes a circuit board, and the circuit board is configured to control operating of the power transistors in the plurality of power modules. In the first direction, the plurality of power modules are separately arranged in a stacked manner with the circuit board, to facilitate control of the circuit board over the plurality of power modules. The circuit board includes an isolation belt, a plurality of power transistor signal terminal connecting regions, a power supply circuit component mounting region, a control circuit component, and a control signal interface mounting region. In the second direction, the power supply circuit component mounting region, the control circuit component mounting region, and the control signal interface mounting region are sequentially distributed at intervals, and the plurality of power transistor signal terminal connecting regions are sequentially distributed at intervals. In the third direction, the plurality of power transistor signal terminal connecting regions are distributed on one side of the isolation belt, and the power supply circuit component mounting region, the control circuit component mounting region, and the control signal interface mounting region are distributed on the other side of the isolation belt. In this manner, the isolation belt divides the circuit board into two regions, so that utilization of space of the circuit board can be higher. In addition, interference between the regions on the two sides of the isolation belt can be reduced. Therefore, more devices can be integrated on the circuit board, and a quantity of circuit boards in the motor controller is reduced.

In an embodiment, the motor controller includes an upper housing and a lower housing, and the liquid cooling heat sink and the integrated component are arranged between the upper housing and the lower housing in a stacked manner in the first direction. The upper housing and the lower housing can be further configured to accommodate other parts in the motor controller. The lower housing includes two coolant channels, and the two coolant channels are respectively configured to connect to the two coolant through holes.

In an embodiment, the lower housing includes two coolant openings, each coolant opening is configured to connect to one coolant through hole, and an orientation of each coolant opening is in the first direction. This facilitates a connection between the coolant opening and the coolant through hole. In the second direction, a spacing between the two coolant openings is less than the length of the liquid cooling heat sink. This can enable the two coolant openings to correspond to the coolant through holes in the first direction. In the third direction, a diameter of each coolant opening is less than the width of the liquid cooling heat sink. This prevents leakage of the coolant when the coolant enters the coolant through hole through the coolant opening.

In an embodiment, the lower housing includes two coolant interfaces, and each coolant interface is configured to connect to one coolant opening through one coolant channel. The orientation of each coolant opening is in the third direction, and the spacing between the two coolant openings in the second direction is less than the length of the liquid cooling heat sink. The coolant interface is configured to allow an external coolant to flow to the liquid cooling heat sink through one coolant opening and one coolant opening, to provide a cooling source for the liquid cooling heat sink.

In an embodiment, the upper housing includes a control signal connecting piece mounting hole and a plurality of direct current connecting piece mounting holes. The control signal connecting piece mounting hole is configured to mount a control signal connecting piece, the control signal connecting piece is configured to receive a control signal, and an orientation of an opening of the signal connecting piece is in the second direction. The control signal connecting piece mounting hole is provided, to facilitate an electrical connection between the control signal connecting piece and a control signal interface. The plurality of direct current connecting piece mounting holes are respectively configured to mount a plurality of direct current connecting pieces, orientations of openings of the plurality of direct current connecting piece mounting holes include at least one of the first direction or the second direction, and the plurality of direct current connecting pieces are separately configured to transmit a direct current. The plurality of direct current connecting piece mounting holes are provided to facilitate an electrical connection between the plurality of direct current connecting pieces and a filter.

According to a third aspect, an embodiment of this application provides a powertrain. The powertrain includes a motor and the motor controller in any technical solution of the second aspect, and the motor controller is electrically connected to the motor. The motor controller is configured to: convert a direct current provided by a power supply into an alternating current, and output the alternating current to the motor.

### BRIEF DESCRIPTION OF DRAWINGS

FIG. 1 is a diagram of a vehicle according to an embodiment of this application;
FIG. 2 is a diagram of a vehicle and a powertrain according to an embodiment of this application;
FIG. 3 is a diagram of a motor controller according to an embodiment of this application;
FIG. 3a is an exploded view of FIG. 3;
FIG. 3b is another exploded view of FIG. 3;
FIG. 4 is another diagram of a motor controller according to an embodiment of this application;
FIG. 4a is an exploded view of FIG. 4;
FIG. 5 is another diagram of a motor controller according to an embodiment of this application;
FIG. 6 is a top view of FIG. 5;
FIG. 7 is another diagram of an integrated component according to an embodiment of this application;
FIG. 8 is a diagram of a Hall magnetic core in an integrated component according to an embodiment of this application;
FIG. 9 is a diagram of a liquid cooling heat sink and power modules according to an embodiment of this application;
FIG. 10 is a top view of a liquid cooling heat sink and power modules according to an embodiment of this application;
FIG. 11 is a bottom view of a liquid cooling heat sink and power modules according to an embodiment of this application;
FIG. 12 is a diagram of a circuit board according to an embodiment of this application;
FIG. 13 is another diagram of a circuit board according to an embodiment of this application;
FIG. 14 is a diagram of an upper housing of a motor controller according to an embodiment of this application;
FIG. 15 is a bottom view of FIG. 14;
FIG. 16 is another diagram of an upper housing of a motor controller according to an embodiment of this application;
FIG. 17 is another diagram of a motor controller according to an embodiment of this application;
FIG. 18 is a bottom view of FIG. 17; and
FIG. 19 is a diagram of a clamping piece in FIG. 17.

### Reference numerals:

1: vehicle; 10: vehicle body; 11: wheel; 12: vehicle-mounted load; 13: external power supply; 2: powertrain; 20: power supply module; 21: power battery; 22: motor; 3: motor controller; 30: integrated component; 301: integrated housing; 302: capacitor core; 3010: supporting column; 3011a and 3011b: limiting piece; 30110: positioning groove; 3012: fastening column; 3013, 3013a, and 3013b: coolant through hole; 3014: Hall magnetic core; 30140: magnetic core through hole; 30141: opening; 3015: copper bar connecting piece; 3016: mounting groove; 3017: filter cavity; 303: direct current output terminal; 31: liquid cooling heat sink; 310: heat sink fastening hole; 311: coolant inlet; 312: coolant outlet; 32: power module; 320: power transistor; 321: direct current power input terminal; 322: alternating current power output terminal; 323: power transistor signal terminal; 33: circuit board; 33a: metal wire; 33b: lower partition board; 33c: power supply circuit component mounting region; 33d: control circuit component mounting region; 33e: control signal interface mounting region; 330: power transistor signal terminal connecting region; 3300: power transistor signal terminal interface; 331: fastening hole; 332: isolation belt; 333: control signal interface; 334: control circuit; 335: power supply circuit; 34: filter module; 340: filter; 341: direct current transmission piece; 342: grounding structure; 35: clamping piece; 350: upper clamping part; 3500: upper connecting board; 3501: upper clamping board; 3502: guide board; 351: lower clamping part; 3510: lower connecting board; 3511: lower clamping board; 3512: buckle; 352: body part; 3520: connecting section; 3521: weight reduction hole; 353: avoidance opening; 36: upper housing; 360: sub-side board; 3600: flange; 3601: control signal connecting piece mounting hole; 361: direct current connecting piece mounting hole; 362: control signal shielding protrusion; 3620: annular protrusion; 363: direct current shielding protrusion; 364: connecting board; 3640: positioning hole; 37: lower housing; 370: coolant channel; 371: coolant opening; 372: coolant interface; 373: alternating current connecting piece mounting hole; 38: three-phase copper bar component; 39: control signal connecting piece.

### DESCRIPTION OF EMBODIMENTS

To make the objectives, technical solutions, and advantages of this application clearer, the following further describes this application in detail with reference to the accompanying drawings.

A motor controller is a core component for controlling an electric assembly in an electric vehicle. Currently, electric vehicles represented by battery electric vehicles and hybrid electric vehicles are increasingly popular with consumers, and interior space and comfort of the electric vehicles also continuously increase. A motor controller in an electric vehicle is configured to convert a direct current provided by a power battery into an alternating current to supply power to a drive motor, thereby driving wheels of the electric vehicle by using the drive motor.

However, there are a large quantity of parts in the motor controller, and connection relationships between the components and parts are complex. As a result, an assembly process of the motor controller is complex, and a gap between the parts in the motor controller is large. Consequently, a size of the motor controller is large. The motor controller has a large size, and is not conducive to a vehicle layout. In addition, parts inside the motor controller need to be disassembled one by one in a rework or maintenance process, and disassembly and assembly operations are complex.

In the conventional technology, the motor controller generally performs signal transmission according to a high-speed communication protocol, to improve a signal transmission rate of an electronic controller. However, when signal transmission is performed according to the high-speed communication protocol, a protection structure needs to be disposed in the motor controller. However, disposition of the protection structure makes assembly of the motor controller more complex, and further increases a quantity of parts in the motor controller, resulting in a large size of the motor controller after assembly of the parts is completed, and being not conducive to a vehicle layout. Therefore, a motor controller having high integration and a small size is urgently needed.

Terms used in the following embodiments are merely intended to describe specific embodiments, but are not intended to limit this application. Terms "one", "a", "the", "the foregoing", "this", and "the one" of singular forms used in this specification and the appended claims of this application are also intended to include expressions such as "one or more", unless otherwise specified in the context clearly.

Reference to "an embodiment", "some embodiments", or the like described in this specification indicates that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. Terms "include", "comprise", "have", and their variants all mean "include but are not limited to", unless otherwise specifically emphasized in another manner.

In this application, a first direction X, a second direction Y, and a third direction Z are perpendicular to each other. It should be noted that perpendicularity defined in embodiments of this application is not limited to an absolute intersection angle of 90 degrees. A non-absolute perpendicular intersection relationship caused by factors such as an assembly tolerance, a design tolerance, and a structural flatness is allowed, and an error within a small angle range is allowed. For example, 80 degrees to 100 degrees may be understood as a perpendicular relationship within an assembly error range.

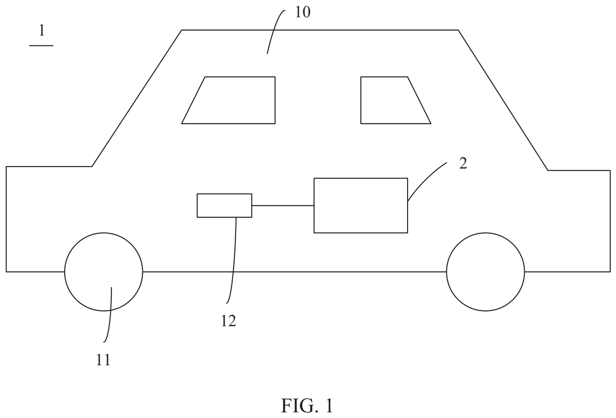

FIG. 1 is a diagram of a vehicle according to this application. Refer to FIG. 1. A vehicle 1 includes a vehicle body 10, wheels 11, a power battery 21, and a powertrain 2. The powertrain 2 is mounted on the vehicle body 10, and the power battery 21 supplies power to the powertrain 2. The powertrain 2 is configured to drive the wheels 11 of the vehicle 1. In an embodiment, the vehicle 1 includes the wheels 11 and the powertrain 2. The powertrain 2 is configured to drive the wheels 11 of the vehicle 1.

In this application, the vehicle 1 includes an electric vehicle (Electric Vehicle, EV), a battery electric vehicle (Battery Electric Vehicle, BEV), a hybrid electric vehicle (Hybrid Electric Vehicle, HEV), a range extended electric vehicle (Range Extended Electric Vehicle, REEV), a plug-in hybrid electric vehicle (Plug-in Hybrid Electric Vehicle, PHEV), or a new energy vehicle (New Energy Vehicle).

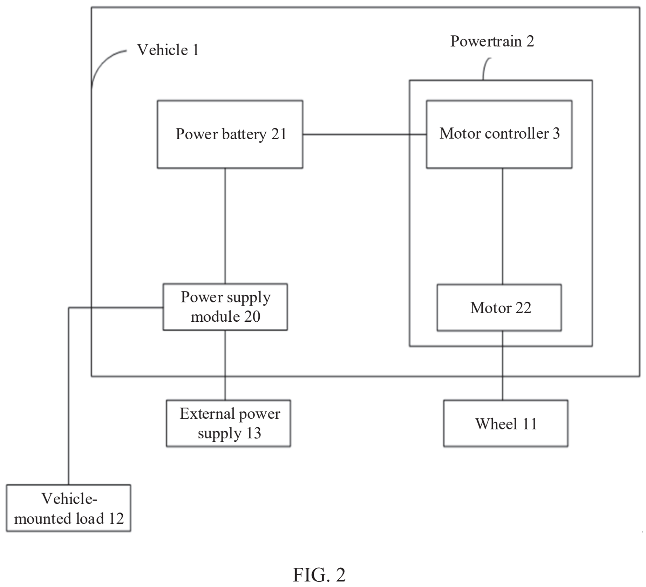

FIG. 2 is a diagram of a vehicle and a powertrain according to an embodiment of this application. As shown in FIG. 1 and FIG. 2, the vehicle 1 includes the vehicle body 10, the wheels 11, the power battery 21, a power supply module 20, a vehicle-mounted load 12, and the powertrain 2.

In an embodiment, the powertrain 2 includes a motor controller 3 and a motor 22. Refer to FIG. 2. The power battery 21 supplies power to the motor 22 by using the motor controller 3. The motor controller 3 is configured to convert a direct current provided by the power battery 21 into an alternating current. The motor 22 receives the alternating current and converts the alternating current into kinetic energy to drive the wheels 11.

In an embodiment, the power supply module 20 is configured to: receive power supplied by an external power supply 13 and charge the power battery 21. In an embodiment, the power supply module 20 is configured to supply power to the vehicle-mounted load 12.

In this application, the external power supply 13 may be an alternating current power grid, an alternating current charging pile, or a direct current charging pile. The power supply module 20 may be a power distribution unit or an on-board charger. The vehicle-mounted load 12 includes at least one of a compressor, a battery heating module, a seat heating module, and a direct current low-voltage power supply.

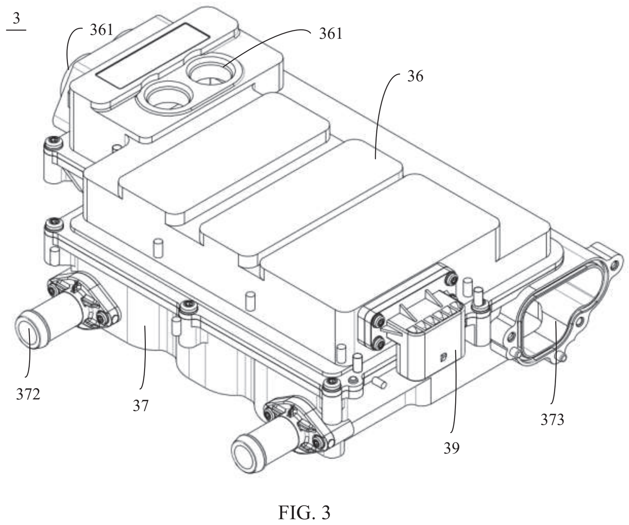

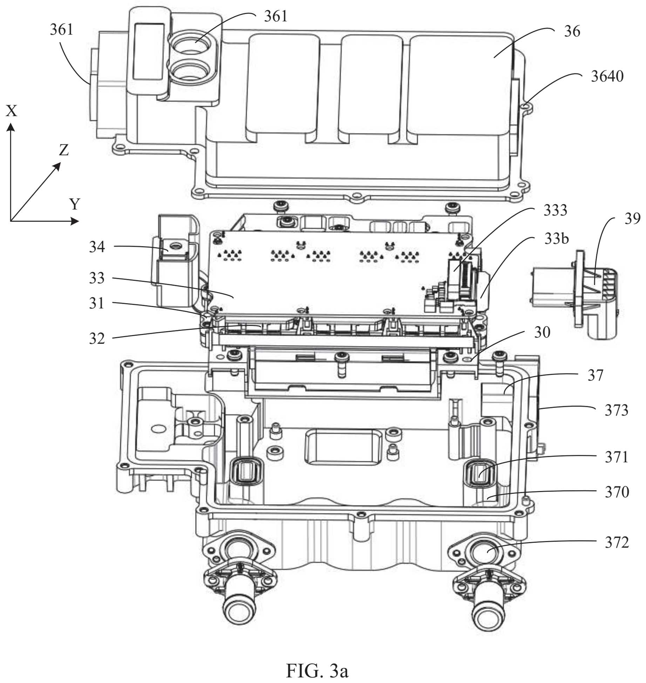

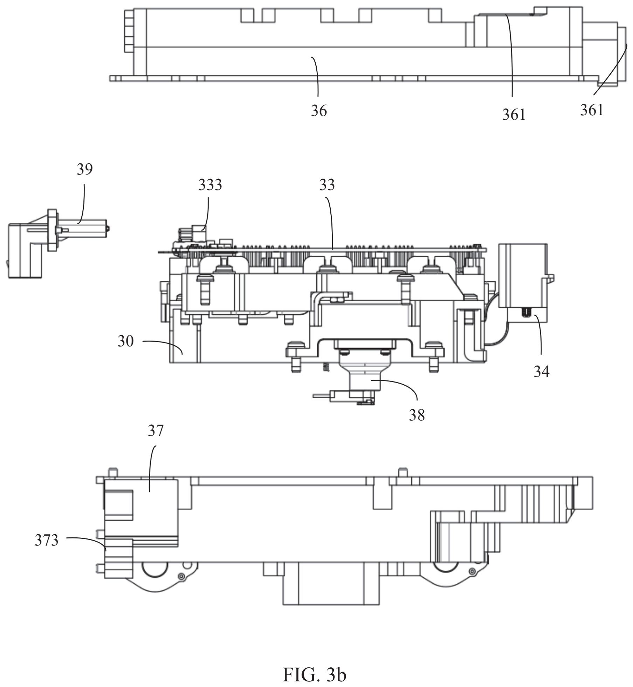

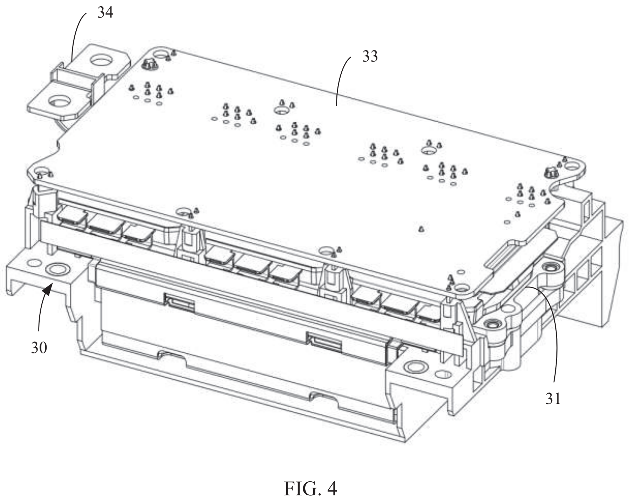

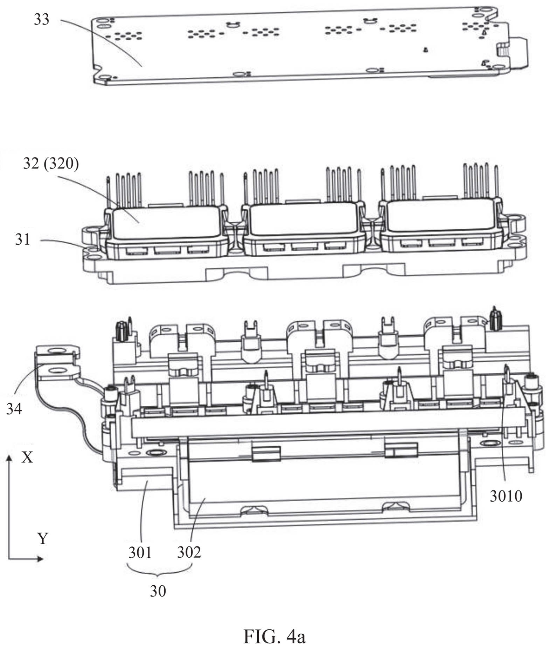

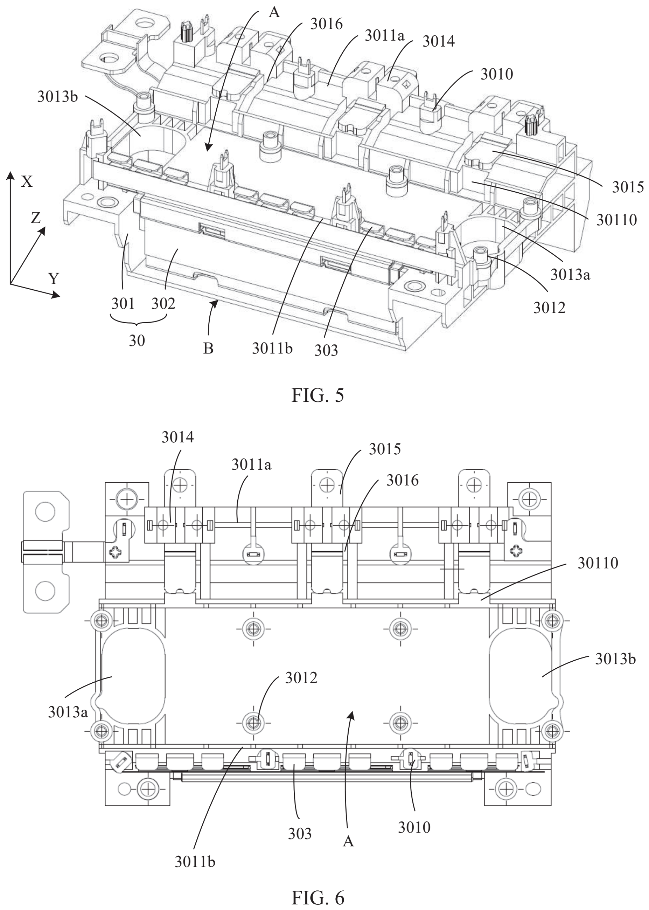

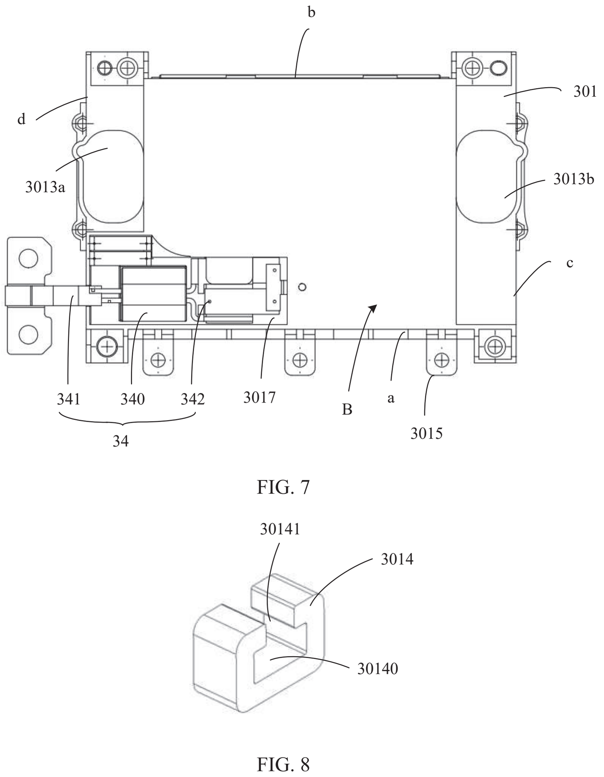

FIG. 3 is a diagram of a motor controller according to an embodiment of this application. FIG. 3a is an exploded view of FIG. 3. FIG. 3b is another exploded view of FIG. 3. FIG. 4 is another diagram of a motor controller according to an embodiment of this application. FIG. 4a is an exploded view of FIG. 4. FIG. 5 is another diagram of a motor controller according to an embodiment of this application. FIG. 7 is another diagram of an integrated component according to an embodiment of this application. FIG. 6 is a top view of FIG. 5. For ease of description, refer to FIG. 3, FIG. 3a, FIG. 3b, FIG. 4a, FIG. 5, FIG. 6, and FIG. 7.

In an embodiment, the motor controller 3 includes an integrated component 30, a liquid cooling heat sink 31, a plurality of power modules 32, a circuit board 33, a filter module 34, an upper housing 36, a lower housing 37, a three-phase copper bar component 38, and a control signal connecting piece 39. The upper housing 36 and the lower housing 37 are combined to form an accommodation cavity of the motor controller 3. The accommodation cavity is configured to accommodate the integrated component 30, the liquid cooling heat sink 31, the plurality of power modules 32, the circuit board 33, the filter module 34, and the three-phase copper bar component 38.

In an embodiment, the upper housing 36 includes a control signal connecting piece mounting hole 3601 and a plurality of direct current connecting piece mounting holes 361. The control signal connecting piece mounting hole 3601 is configured to mount the control signal connecting piece 39. An orientation of an opening of the control signal connecting piece mounting hole 3601 is in a second direction X. The control signal connecting piece 39 is configured to connect to an external signal transmission line. An orientation of an opening of the control signal connecting piece 39 is in a first direction X. Orientations of openings of the plurality of direct current connecting piece mounting holes 361 include at least one of the first direction X and the second direction Y. The plurality of direct current connecting piece mounting holes 361 are respectively configured to mount a plurality of direct current connecting pieces.

In an embodiment, the lower housing 37 includes two coolant interfaces 372 and an alternating current connecting piece mounting hole 373. The two coolant interfaces 372 are configured to connect to the liquid cooling heat sink 31 and transmit a coolant to dissipate heat for the circuit board 33, the plurality of power modules 32, the integrated component 30, the filter module 34, and the like in the motor controller 3. Orientations of openings of the two coolant interfaces 372 are in a third direction Z. The alternating current connecting piece mounting hole 373 is configured to mount an alternating current connecting piece. The alternating current connecting piece is configured to electrically connect to a three-phase alternating current transmission line and the three-phase copper bar component 38. An orientation of an opening of the alternating current connecting piece mounting hole 373 is in the second direction Y.

In an embodiment, a housing of the motor controller 3 includes the upper housing 36 and the lower housing 37. As shown in FIG. 3, FIG. 3a, and FIG. 3b, in the second direction Y, the alternating current connecting piece mounting hole 373 is arranged on one side of the housing of the motor controller 3, and the plurality of direct current connecting piece mounting holes 361 are arranged on the other side of the housing of the motor controller 3. In the second direction, the alternating current connecting piece mounting hole 373 is arranged on one side of the lower housing 37, and the plurality of direct current connecting piece mounting holes 361 are arranged on the other side of the upper housing 36.

In an embodiment, the circuit board 33, the plurality of power modules 32, the liquid cooling heat sink 31, and the integrated component 30 are arranged in a stacked manner in the first direction X. In an embodiment, the liquid cooling heat sink 31 and the integrated component 30 are arranged between the upper housing 36 and the lower housing 37 in a stacked manner in the first direction X. In an embodiment, the plurality of power modules 32 are arranged between the liquid cooling heat sink 31 and the circuit board 33 in the first direction X. In an embodiment, each power module 32 and the circuit board 33 are arranged in a stacked manner in the first direction X.

In an embodiment, the integrated component 30 includes an integrated housing 301 and a capacitor core 302. The integrated housing 301 is configured to accommodate the capacitor core 302.

In an embodiment, each power module 32 includes at least one power transistor 320. In an embodiment, the power transistors 320 of the plurality of power modules 32 are configured to form a three-phase bridge arm circuit. Two ends of a bridge arm of a bridge arm circuit of each phase are configured to electrically connect to the capacitor core 302 in the integrated component 30, and a neutral point of the bridge arm of the bridge arm circuit of each phase is configured to output an alternating current to drive the motor 22.

In an embodiment, each power module 32 includes at least one power transistor 320. In an embodiment, the power transistors 320 of the plurality of power modules 32 are configured to form a three-phase bridge arm circuit. Two ends of a bridge arm of a bridge arm circuit of each phase are configured to electrically connect to the capacitor core 302 in the integrated component 30, and a neutral point of the bridge arm of the bridge arm circuit of each phase is configured to output an alternating current to drive the motor 22.

In an embodiment, the filter module 34 includes a filter 340, a direct current transmission piece 341, and a grounding structure 342. The filter 340 is configured to electrically connect to the capacitor core 302 in the integrated component 30. The direct current transmission piece 341 is configured to receive, by using one or more direct current connecting pieces mounted in the direct current connecting piece mounting holes 361, the direct current output by the power battery 21. The filter 340 is configured to receive a direct current of the direct current transmission piece 341.

In this application, the direct current output by the power battery 21 is transmitted to the filter 340 and the capacitor core 302 by using the direct current transmission piece 341, and the filter 340 and the capacitor core 302 are configured to reduce harmonics in the direct current. The circuit board 33 and the three-phase bridge arm circuit formed by the plurality of power modules 32 receive the direct current, and output an alternating current to drive the motor 22. The circuit board 33 is configured to control operating of the power transistors 320 in the power modules 32. The circuit board 33 receives a control signal by using the control signal connecting piece 39, to control a parameter of an alternating current output by an inverter circuit. The alternating current output by the three-phase bridge arm circuit is transmitted to a three-phase winding of the motor 22 by using the three-phase copper bar component 38 and the alternating current connecting piece fastened by the alternating current connecting piece mounting hole 373.

In an embodiment, the integrated housing 301 includes two coolant through holes. In an embodiment, the liquid cooling heat sink 31 includes a coolant inlet 311 and a coolant outlet 312. The two coolant through holes of the integrated housing 301 are respectively configured to connect to the coolant inlet 311 and the coolant outlet 312.

Refer to FIG. 4a, FIG. 5, and FIG. 6. The two coolant through holes are respectively a coolant through hole 3013a and a coolant through hole 3013b. In the first direction X, the coolant through hole 3013a and the coolant through hole 3013b separately run through the integrated housing 301. A projection of the coolant through hole 3013a and a projection of the coolant through hole 3013b do not overlap with a projection of the capacitor core 302. Pipelines through which the coolant is introduced into the coolant through hole 3013a and the coolant through hole 3013b do not need to avoid the capacitor core 302, thereby improving mounting convenience.

In the second direction Y, the coolant through hole 3013a and the coolant through hole 3013b are arranged at an interval. The capacitor core 302 is located between the coolant through hole 3013a and the coolant through hole 3013b. In a process of entering the coolant through hole 3013a and the coolant through hole 3013b, the coolant can dissipate heat and cool the capacitor core 302.

In an embodiment, the coolant through hole 3013a and the coolant through hole 3013b are greater than a length of the capacitor core 302 in the first direction X. In an embodiment, a spacing between the coolant through hole 3013a and the coolant through hole 3013b in the second direction Y is less than a length of the liquid cooling heat sink 31. The coolant passes through the coolant through hole 3013a and the coolant through hole 3013b, and the capacitor core 302 is located between the coolant through hole 3013a and the coolant through hole 3013b, to cool the capacitor core 302.

In an embodiment, in the third direction Z, diameters of the coolant through hole 3013a and the coolant through hole 3013b are less than a width of the liquid cooling heat sink 31, to ensure that a possibility of leakage is low in a process in which the coolant through hole 3013a and the coolant through hole 3013b flow into the liquid cooling heat sink 31.

In an embodiment, the diameter of the coolant through hole 3013a and the diameter of the coolant through hole 3013b are greater than the coolant inlet and the coolant outlet of the liquid cooling heat sink 31, thereby improving sealing performance between the coolant through hole 3013a and the coolant inlet of the liquid cooling heat sink 31 and sealing performance between the coolant through hole 3013b and the coolant outlet of the liquid cooling heat sink 31.

Refer to FIG. 4a, FIG. 5, and FIG. 6. The coolant inlet and the coolant outlet of the liquid cooling heat sink 31 are respectively connected to the coolant through hole 3013a and the coolant through hole 3013b. For example, the coolant is transferred to the liquid cooling heat sink 31 through the coolant through hole 3013a, and the coolant in the liquid cooling heat sink 31 flows out through the coolant through hole 3013b.

In this application, the integrated housing 301 integrates the coolant through hole 3013a and the coolant through hole 3013b, and a process of transmitting the coolant through the coolant through hole 3013a and the coolant through hole 3013b may dissipate heat for the capacitor core 302, so that the integrated housing 301 has a function of dissipating heat for the capacitor core 302. In addition, the integrated housing 301 integrates the coolant through hole 3013a and the coolant through hole 3013b. This can improve integration of the motor controller and facilitate miniaturization of the motor controller.

In an embodiment, a shape of the coolant through hole 3013a and a shape of the coolant through hole 3013b are a kidney-shaped hole, a circular hole, a rectangular hole, a diamond-shaped hole, or the like. In an embodiment, sealing rings are respectively disposed between the coolant through hole 3013a and the coolant inlet of the liquid cooling heat sink 31 and between the coolant through hole 3013b and the coolant outlet of the liquid cooling heat sink 31, to ensure the sealing performance between the coolant through hole 3013a and the coolant inlet of the liquid cooling heat sink 31 and the sealing performance between the coolant through hole 3013b and the coolant outlet of the liquid cooling heat sink 31.

In an embodiment, the lower housing 37 includes two coolant channels 370 and two coolant openings 371, and each coolant opening 371 is configured to connect to one coolant through hole. As shown in FIG. 3a, an orientation of each coolant opening 371 is in the first direction X. In the second direction Y, a spacing between the two coolant openings 371 is less than the length of the liquid cooling heat sink 31. In the third direction Z, a diameter of each coolant opening 371 is less than the width of the liquid cooling heat sink 31. This facilitates a connection between the coolant opening 371 and the coolant through hole. It can also ensure that the coolant does not leak.

In an embodiment, the lower housing 37 includes the two coolant interfaces 372, and each coolant interface 372 is configured to connect to one coolant opening 371 through one coolant channel 370. As shown in FIG. 3a, the orientation of each coolant opening 371 is in the third direction Z, and the spacing between the two coolant openings 371 in the second direction Y is less than the length of the liquid cooling heat sink 31. The coolant interface 372 is configured to allow an external coolant to flow to the liquid cooling heat sink 31 through one coolant channel 370 and one coolant opening 371, to provide a coolant for the liquid cooling heat sink 31.

The two coolant interfaces 372, the two coolant channels 370, and the two coolant openings 371 form two pipelines that provide a cold source for the liquid cooling heat sink 31. Inlets of the two pipelines are both connected to a side wall of the lower housing 37, and outlets of the two pipelines are respectively connected to the coolant inlet and the coolant outlet of the liquid cooling heat sink 31.

In an embodiment, with reference to FIG. 4a, FIG. 5, and FIG. 6, the integrated housing 301 includes a first surface A and a second surface B that are opposite to each other in the first direction X. The first surface A of the integrated housing 301 may be understood as a surface that is of the integrated housing 301 and that faces the circuit board 33, and the second surface B of the integrated housing 301 may be understood as a surface that is of the integrated housing 301 and that is away from the circuit board 33.

The first surface A of the integrated housing 301 includes a limiting piece 3011a and a limiting piece 3011b. The limiting piece 3011a and the limiting piece 3011b are arranged on a surface of the integrated housing 301 at an interval. The coolant through hole 3013a and the coolant through hole 3013b are located between the limiting piece 3011a and the limiting piece 3011b.

Refer to FIG. 4a, FIG. 5, and FIG. 6. In the second direction, the limiting piece 3011a and the limiting piece 3011b are arranged on two sides of the coolant through hole 3013a and the coolant through hole 3013b. Space between the limiting piece 3011a and the limiting piece 3011b that are arranged at an interval is used to mount the liquid cooling heat sink 31, and the limiting piece 3011a and the limiting piece 3011b can limit movement of the liquid cooling heat sink 31 in a direction perpendicular to the first direction X and the second direction Y. The limiting piece 3011a and the limiting piece 3011b can limit movement of the liquid cooling heat sink 31 in the third direction Z, to improve stability of the liquid cooling heat sink 31 integrated into the integrated housing 301.

In an embodiment, the first surface A of the integrated housing 301 includes two rows of fastening columns 3012. Still refer to FIG. 4a, FIG. 5, and FIG. 6. The two rows of fastening columns 3012 are arranged between the limiting piece 3011a and the limiting piece 3011b at an interval, and the limiting piece 3011a and the limiting piece 3011b are configured to fasten the liquid cooling heat sink 31.

In an embodiment, the two rows of fastening columns 3012, the limiting piece 3011a, and the limiting piece 3011b are located on a same side of the integrated housing 301. Each row of the fastening columns 3012 includes a plurality of fastening columns 3012 that are arranged at intervals in the second direction. In the first direction X, the two rows of fastening columns 3012 are arranged at an interval in the third direction Z, and the two rows of fastening columns 3012 are configured to fasten the liquid cooling heat sink 31.

In an embodiment, with reference to FIG. 4a, FIG. 5, and FIG. 6, the two rows of fastening columns 3012 are arranged at an interval in the third direction Z.

In an embodiment, each row of the fastening columns 3012 includes four fastening columns 3012 that are arranged in the second direction Y. Refer to FIG. 4a, FIG. 5, and FIG. 6. A mounting region is formed among every four fastening columns 3012, and a plurality of mounting regions are used to mount the liquid cooling heat sink 31. In the second direction Y, one mounting region at one end corresponds to the coolant through hole 3013a, one mounting region at the other end corresponds to the coolant through hole 3013b, and the coolant inlet and the coolant outlet of the liquid cooling heat sink 31 can respectively correspond to the coolant through hole 3013a and the coolant through hole 3013b.

In this application, the integrated housing 301 integrates the fastening columns 3012, and the liquid cooling heat sink 31 is fastened to the integrated housing 301 by using the fastening columns 3012, thereby improving integration of the integrated housing 301.

In an embodiment, the first surface A of the integrated housing 301 includes two rows of supporting columns 3010. Refer to FIG. 4a, FIG. 5, and FIG. 6. The two rows of supporting columns 3010, the two rows of fastening columns 3012, the limiting piece 3011a, and the limiting piece 3011b are located on a same side of the integrated housing 301. In the second direction Y, the two rows of supporting columns 3010 are arranged opposite to each other on two sides of the two rows of fastening columns 3012.

In an embodiment, two rows of supporting columns 3010 are arranged opposite to each other on two sides of the liquid cooling heat sink 31 or the power modules 32. The two rows of supporting columns 3010 are configured to fasten the circuit board 33. In this application, the integrated housing 301 integrates the two rows of supporting columns 3010, so that the motor controller 3 is compact in a structural layout and has high integration. This helps implement a miniaturization design of the motor controller 3, and reduces difficulty and costs of disassembling and assembling internal parts of the motor controller 3.

In an embodiment, each row of the supporting columns 3010 includes a plurality of supporting columns 3010 that are arranged at intervals in the second direction Y. In the third direction Z, the limiting piece 3011a and the limiting piece 3011b each integrate one row of supporting columns 3010. Correspondingly, a height of the supporting column 3010 is greater than a height of the fastening column 3012 in the first direction X, so that a size of the integrated housing 301 in the first direction X can be reduced.

In an embodiment, each row of the supporting columns 3010 includes a plurality of supporting columns 3010 that are arranged at intervals in the first direction X. In the third direction Z, each supporting column 3010 passes through the limiting piece 3011a and the limiting piece 3011b and is fastened to the first surface A of the integrated housing 301.

In an embodiment, each row of the supporting columns 3010 includes a plurality of supporting columns 3010 that are arranged at intervals in the second direction Y. In the third direction Z, the two rows of supporting columns 3010 are arranged at an interval, the two rows of fastening columns 3012 are arranged at an interval between the two rows of supporting columns 3010, and a spacing between the two rows of fastening columns 3012 is less than the width of the liquid cooling heat sink 31. Correspondingly, the height of the supporting column 3010 is also greater than the height of the fastening column 3012 in the first direction X, so that the size of the integrated housing 301 in the first direction X can be reduced.

In an embodiment, the integrated component 30 includes a plurality of Hall magnetic cores 3014 and a plurality of copper bar connecting pieces 3015. One end of the copper bar connecting piece 3015 is configured to electrically connect to one power transistor 320, to output an alternating current of the power module 32.

In an embodiment, the first surface A of the integrated housing 301 includes a plurality of mounting grooves 3016, the plurality of mounting grooves 3016 are provided at intervals in the second direction Y, and each mounting groove 3016 is configured to mount one Hall magnetic core 3014. FIG. 8 is a diagram of a structure of a Hall magnetic core in an integrated component according to an embodiment of this application. Refer to FIG. 5, FIG. 6, FIG. 7, and FIG. 8. The mounting grooves 3016, the two rows of supporting columns 3010, the two rows of fastening columns 3012, the limiting piece 3011a, and the limiting piece 3011b are located on a same side of the integrated housing 301.

In an embodiment, the Hall magnetic cores 3014 are fastened to the mounting grooves 3016 in a bonding manner, so that the plurality of Hall magnetic cores 3014 are arranged at intervals in the second direction Y.

In an embodiment, the limiting piece 3011a includes the mounting grooves 3016, and the Hall magnetic cores 3014 are bonded to the mounting grooves 3016 of the limiting piece 3011a.

In an embodiment, the Hall magnetic core 3014 includes a magnetic core through hole 30140, and an axis of the magnetic core through hole 30140 is perpendicular to the first direction X and the second direction Y. Each magnetic core through hole 30140 is configured to allow one copper bar connecting piece 3015 to pass through.

In an embodiment, the Hall magnetic core 3014 includes an opening 30141. The opening is away from the integrated housing 301 in the first direction X. The opening 30141 is connected to the magnetic core through hole 30140. The opening 30141 is configured to accommodate a detection device. The detection device is configured to detect a current flowing through the copper bar connecting piece 3015 or a voltage of the copper bar connecting piece 3015.

Refer to FIG. 5, FIG. 6, and FIG. 8. The copper bar connecting piece 3015 passes through the magnetic core through hole 30140, and there is no electrical connection between the copper bar connecting piece 3015 and the Hall magnetic core 3014. In this application, in the first direction X and the second direction Y, there is a gap between the copper bar connecting piece 3015 and an inner wall of the magnetic core through hole 30140, to ensure stability of an alternating current output through the copper bar connecting piece 3015.

In an embodiment, the plurality of Hall magnetic cores 3014 are arranged at intervals in the second direction Y. In an embodiment, the limiting piece 3011a includes the plurality of Hall magnetic cores 3014. For example, the plurality of Hall magnetic cores 3014 and the limiting piece 3011a are integrally formed. In an embodiment, a material of the Hall magnetic core 3014 may be a magnetic material like silicon steel or a nickel core.

In an embodiment, in the second direction Y, one Hall magnetic core 3014 is arranged between two adjacent supporting columns 3010, to improve space utilization of the first surface A of the integrated housing 301.

In an embodiment, the integrated component 30 includes a plurality of direct current output terminals 303. The plurality of direct current output terminals 303 are arranged at intervals in the second direction Y. Refer to FIG. 4a, FIG. 5, and FIG. 6. The plurality of direct current output terminals 303 form three groups of direct current output terminals 303. The three groups of direct current output terminals 303 are respectively configured to correspond to three power modules 32. One end of each group of the direct current output terminals 303 is electrically connected to the power transistor 320 in one of the power modules 32, and the other end of each group of the direct current output terminals 303 is configured to be electrically connected to the capacitor core 302.

In an embodiment, each group of the direct current output terminals 303 and one copper bar connecting piece 3015 are arranged opposite to each other. In the second direction Y, a projection of one of the copper bar connecting pieces 3015 is located in a projection of one group of the direct current output terminals 303, to ensure that the copper bar connecting piece 3015 does not occupy more space in the second direction Y. This improves compactness of the motor controller. In the first direction X, a height of the direct current output terminal 303 is less than a height of the copper bar connecting piece 3015, so that the direct current output terminal 303 and one of the copper bar connecting pieces 3015 are electrically connected to the power module.

In an embodiment, each group of the direct current output terminals 303 includes two positive direct current output terminals and one negative direct current output terminal. In the second direction Y, one negative direct current output terminal is arranged between two positive direct current output terminals.

In an embodiment, a side that is of the limiting piece 3011a and that faces the limiting piece 3011b includes a plurality of positioning grooves 30110, and the plurality of positioning grooves 30110 are arranged at intervals in the second direction Y. A part of the copper bar connecting piece 3015 is fastened to the positioning groove 30110.

In the foregoing embodiment, the integrated housing 301 can integrate the two coolant through holes 3013a and 3013b, the two limiting pieces 3011a and 3011b, the two rows of supporting columns 3010, the two rows of fastening columns 3012, and the Hall magnetic cores 3014, so that the motor controller 3 is compact in a structural layout and has high integration. This helps implement a miniaturization design of the motor controller 3, and reduces difficulty and costs of disassembling and assembling internal parts of the motor controller.

Still refer to FIG. 7. In an embodiment, the filter module 34 includes a filter 340, a direct current transmission piece 341, and a grounding structure 342. The first surface of the integrated housing 301 is configured to fasten the liquid cooling heat sink 31 and the circuit board 33, and the second surface is configured to mount the filter 340. The second surface B of the integrated housing 301 includes a filter cavity 3017, and the filter cavity 3017 is configured to mount the filter 340.

In an embodiment, the filter 340 is mounted on the second surface of the integrated housing 301 by using the filter cavity 3017. Refer to FIG. 3b and FIG. 7. The second surface B of the integrated housing 301 includes the filter cavity 3017. The filter cavity 3017 is configured to mount the filter 340.

In an embodiment, in the first direction X, the grounding structure 342 is electrically connected to the filter 340 and protrudes from the filter cavity 3017. Refer to FIG. 3b and FIG. 8. The grounding structure 342 is mounted on the filter 340 and protrudes from the second surface of the integrated housing 301. The grounding structure 342 is electrically connected to a side that is of the filter 340 and that is away from the liquid cooling heat sink 31, and the grounding structure 342 protrudes from the filter cavity 3017 in the first direction X. In the second direction Y, a length of the filter 340 is less than a length of the second surface of the integrated housing 301.

In this application, the grounding structure 342 is electrically connected to the side that is of the filter 340 and that is away from the liquid cooling heat sink 31, and protrudes from the filter cavity 3017 in the first direction X. The integrated housing 301 is mounted on the lower housing 37, and the grounding structure 342 can abut against a bottom surface of the lower housing, thereby improving stability of mounting the filter module on the integrated housing 301. In addition, the grounding structure 342 protrudes from the second surface. This can also ensure that the grounding structure 342 is in contact with the lower housing 37, and improve working stability of the filter module 34.

In an embodiment, the second surface B of the integrated housing 301 includes a first side a, a second side b, a third side c, and a fourth side d. The first side a and the second side b are disposed opposite to each other, and the third side c and the fourth side d are disposed opposite to each other. A part of the copper bar connecting piece 3015 protrudes from the integrated housing 301. The coolant through hole 3013a and the coolant through hole 3013b are located between the first side a and the second side b, the coolant through hole 3013a is close to the fourth side d, and the coolant through hole 3013b is close to the third side c. The spacing between the coolant through hole 3013a and the coolant through hole 3013b is large, so that mounting of the capacitor core can be ensured. The coolant through hole 3013a and the coolant through hole 3013b are distributed on two sides of the integrated housing 301. This facilitates the integrated housing 301 to integrate components such as the mounting grooves 3016, the supporting columns 3010, and the fastening columns 3012.

In an embodiment, the filter cavity 3017 is arranged between the coolant through hole 3013a and the copper bar connecting piece 3015. It may be understood that, after the filter 340 is mounted on the integrated housing 301, the filter 340 is located between the coolant through hole 3013a and the copper bar connecting piece 3015. One end of the direct current transmission piece 341 is connected to the filter 340, the other end of the direct current transmission piece 341 is located on one side of the fourth side d, and the other end of the direct current transmission piece 341 extends to the first surface of the integrated housing 301, so that interference caused by the direct current transmission piece 341 to the copper bar connecting piece 3015 is small. Because the direct current output terminal 303 and the copper bar connecting piece 3015 are arranged opposite to each other, a location of the direct current transmission piece 341 is far away from the direct current output terminal 303, and interference caused by the direct current transmission piece 341 to the direct current output terminal 303 is less than that to the copper bar connecting piece 3015.

In an embodiment, the filter cavity 3017 is arranged between the coolant through hole 3013b and the copper bar connecting piece 3015 in the third direction Z. As shown in FIG. 7, the filter 340 is mounted in the filter cavity 3017 of the integrated housing 301, and the filter 340 is located between the coolant through hole 3013b and the copper bar connecting piece 3015.

In an embodiment, one end of the direct current transmission piece 341 is electrically connected to the filter 340, and the other end of the direct current transmission piece 341 is configured to electrically connect to the direct current connecting piece. As shown in FIG. 8, the other end of the direct current transmission piece 341 is located on one side of the third side c, and the other end of the direct current transmission piece 341 extends to the first surface of the integrated housing 301 in the second direction Y, to reduce the interference caused by the direct current transmission piece 341 to the copper bar connecting piece 3015.

In an embodiment, the direct current transmission piece 341 and the signal connecting piece 39 are arranged opposite to each other in the second direction Y. Refer to FIG. 3a and FIG. 8. The direct current transmission piece 341 and the signal connecting piece 39 are arranged on two sides of the liquid cooling heat sink 31 in the second direction Y, to reduce interference caused by the direct current transmission piece 341 to the signal connecting piece 39.

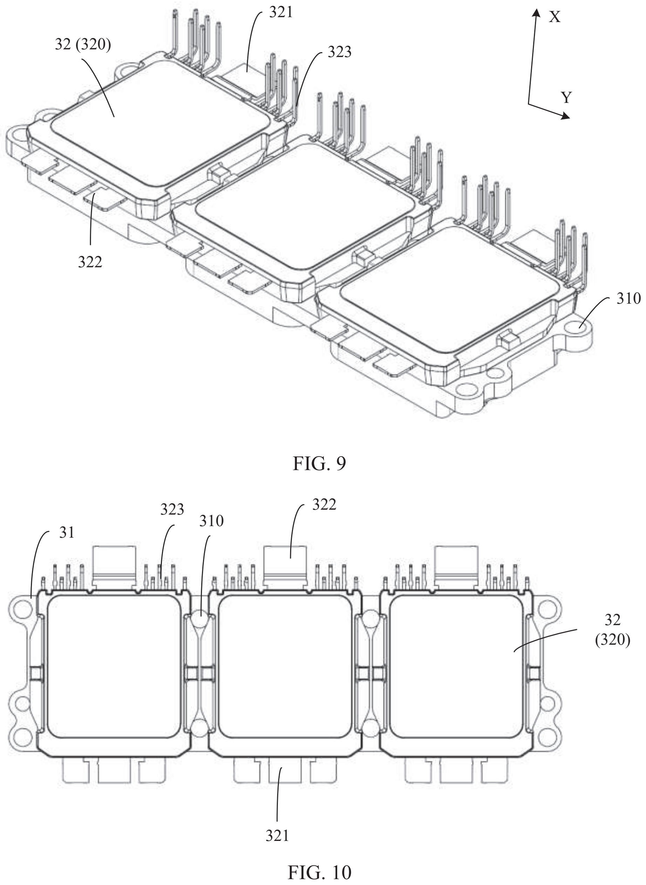

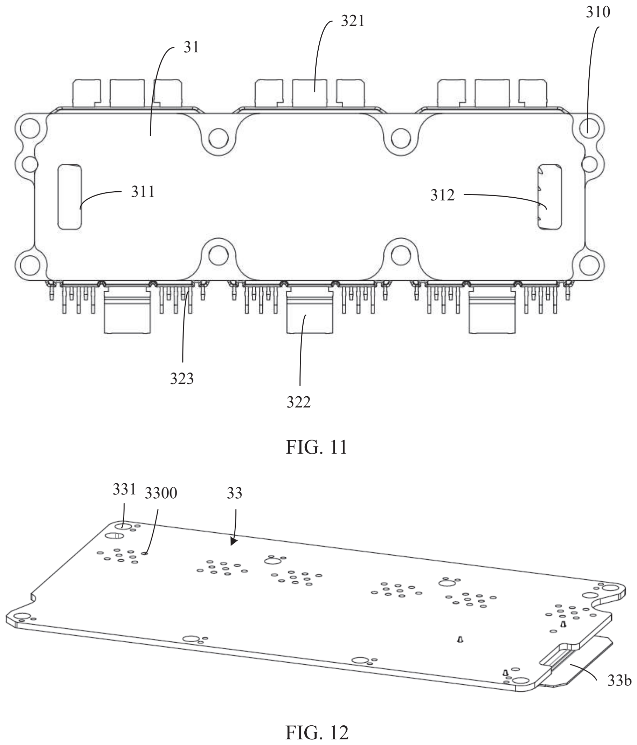

FIG. 9 is a diagram of a liquid cooling heat sink and power modules according to an embodiment of this application. FIG. 10 is a top view of a liquid cooling heat sink and power modules according to an embodiment of this application. FIG. 11 is a bottom view of a liquid cooling heat sink and power modules according to an embodiment of this application.

In an embodiment, the plurality of power modules 32 are fastened to the liquid cooling heat sink 31. In the first direction X, the plurality of power modules 32 are separately arranged in a stacked manner with the liquid cooling heat sink 31. In the second direction Y, the plurality of power modules 32 are arranged at intervals. Refer to FIG. 4a, FIG. 9, FIG. 10, and FIG. 11. The power modules 32 are arranged on a surface of the liquid cooling heat sink 31 at intervals in the second direction Y. In this application, the plurality of power modules 32 are tiled and arranged on the surface of the liquid cooling heat sink 31 in the second direction Y. This helps reduce a length of the motor controller 3 in the first direction X, and effectively utilizes a mounting area of the liquid cooling heat sink 31, so that a miniaturization design of the motor controller can be implemented.

In an embodiment, the power transistors 320 of the plurality of power modules 32 are configured to form the three-phase bridge arm circuit. Two ends of a bridge arm of a bridge arm circuit of each phase are configured to electrically connect to the capacitor core 302, and a neutral point of the bridge arm of the bridge arm circuit of each phase is configured to output an alternating current. For example, the motor controller 3 includes three power modules 32. Each power module 32 includes a one-phase bridge arm circuit. Each power module 32 includes at least one bridge arm circuit. Each bridge arm circuit includes two power transistors 320. The two power transistors 320 respectively form an upper bridge arm switching transistor and a lower bridge arm switching transistor of the one-phase bridge arm circuit.

In an embodiment, the power transistor 320 includes at least one of an insulated gate bipolar transistor (Insulated Gate Bipolar Transistor, IGBT) or a metal-oxide-semiconductor field-effect transistor (Metal-Oxide-Semiconductor Field-Effect Transistor, MOS). In an embodiment, the power transistor 320 includes a silicon carbide metal-oxide-semiconductor field-effect transistor (silicon carbide metal-oxide-semiconductor field-effect transistor, SiC MOSFET) or a silicon-based insulated gate bipolar transistor (silicon-insulated-gate bipolar transistors, Si IGBT).

In an embodiment, each power module 32 includes a plurality of direct current power input terminals 321, an alternating current power output terminal 322, and a plurality of power transistor signal terminals 323. The direct current power input terminal 321 is configured to electrically connect to the capacitor core 302 by using the direct current output terminal 303. The power transistor signal terminal 323 is configured to electrically connect to the circuit board 33. The alternating current power output terminal 322 is configured to electrically connect to the copper bar connecting piece 3015. The power transistor signal terminal 323 is configured to electrically connect to the power transistor 320 in the power module 32.

In an embodiment, the plurality of direct current power input terminals 321 in each power module 32 are arranged on one side of the power module 32 in the third direction Z, and the plurality of power transistor signal terminals 323 and one alternating current power output terminal 322 in each power module 32 are arranged on the other side of the power module 32 in the third direction Z. In the second direction Y, the plurality of alternating current power output terminals 322 of the plurality of power modules 32 are sequentially arranged at intervals.

As shown in FIG. 8 and FIG. 9, each power module 32 includes three direct current power input terminals 321, one alternating current power output terminal 322, and a plurality of power transistor signal terminals 323. For example, each power module 32 includes twelve power transistors 320 and twelve power transistor signal terminals 323. Six power transistors 320 form the upper bridge arm switching transistor of the one-phase bridge arm circuit, and the other six power transistors 320 form the lower bridge arm switching transistor of the one-phase bridge arm circuit. The twelve power transistor signal terminals 323 are respectively configured to electrically connect to control ends of the twelve power transistors 320.

As shown in FIG. 9 and FIG. 10, three direct current power input terminals 321 of each power module 32 are arranged on one side of the power module 32 in the third direction Z. One alternating current power output terminal 322 and the plurality of power transistor signal terminals 323 of each power module 32 are arranged on the other side of the power module 32 in the third direction Z.

Nine direct current power input terminals 321 of the three power modules 32 are arranged on one side in the third direction Z. In the second direction Y, the nine direct current power input terminals 321 of the three power modules 32 are arranged at intervals in the second direction Y. Three alternating current power output terminals 322 and twelve power transistor signal terminals 323 of the three power modules 32 are arranged on the other side in the third direction Z. In the second direction Y, the three alternating current power output terminals 322 of the three power modules 32 are arranged at intervals.

An extension direction of each direct current power input terminal 321 is away from the power module 32 in the third direction Z, to facilitate an electrical connection of the direct current power input terminal 321 to the capacitor core 302. An extension direction of the alternating current power output terminal 322 of each power module 32 is away from the power module 32 in the third direction Z, to facilitate an electrical connection to the copper bar connecting piece 3015. The power transistor signal terminal 323 of each power module 32 is away from the power module 32 in the first direction X, to facilitate an electrical connection to the circuit board 33.

In an embodiment, the power transistor signal terminal 323 is a pin. The power transistor signal terminal 323 is inserted into the circuit board 33 to implement an electrical connection between the power module 32 and the circuit board 33. The circuit board 33 transmits a control signal to the power transistor 320 in the power module 32 by using the power transistor signal terminal 323. In an embodiment, the liquid cooling heat sink 31 includes two rows of heat sink fastening holes 310. As shown in FIG. 10 and FIG. 11, each row of the heat sink fastening holes 310 includes four heat sink fastening holes 310. In the second direction Y, the four heat sink fastening holes 310 are arranged at intervals. In the two rows of heat sink fastening holes 310, one power module 32 is arranged among four heat sink fastening holes 310 that are arranged opposite to each other. The four heat sink fastening holes 310 are configured to cooperate with four fastening columns, so that the liquid cooling heat sink 31 is stably mounted on the integrated housing 301.

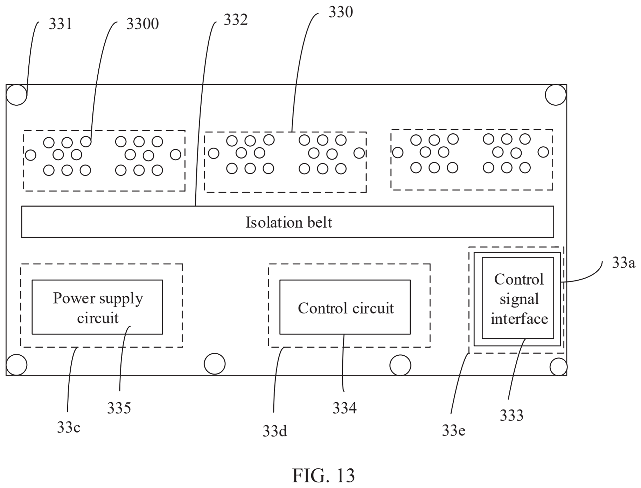

FIG. 12 is a diagram of a circuit board according to an embodiment of this application. FIG. 13 is another diagram of a circuit board according to an embodiment of this application. As shown in FIG. 12 and FIG. 13, the circuit board 33 includes an isolation belt 332, a plurality of power transistor signal terminal connecting regions 330, a power supply circuit component mounting region 33c, a control circuit component mounting region 33d, and a control signal interface mounting region 33e.

In the second direction Y, the power supply circuit component mounting region 33c, the control circuit component mounting region 33d, and the control signal interface mounting region 33e are sequentially distributed at intervals, and the plurality of power transistor signal terminal connecting regions 330 are sequentially distributed at intervals.

In the third direction Z, the plurality of power transistor signal terminal connecting regions 330 are distributed on one side of the isolation belt 332, and the power supply circuit component mounting region 33c, the control circuit component mounting region 33d, and the control signal interface mounting region 33e are distributed on the other side of the isolation belt 332.

The control circuit component mounting region 33d is configured to mount a circuit component of a control circuit 334, the control signal interface mounting region 33e is configured to mount a control signal interface 333, and the power supply circuit component mounting region 33c is configured to mount a circuit component of a power supply circuit 335. The control signal interface 333 is configured to receive the control signal, the control circuit 334 is configured to control the power transistors 320 in the plurality of power modules 32 based on the control signal, and the power supply circuit 335 is configured to: receive a direct current and supply power to the control circuit 334.

As shown in FIG. 13, the control signal interface mounting region 33e is located at an edge of the circuit board 33. As shown in FIG. 3a, the control signal interface 333 is located at an edge of the circuit board 33, to facilitate an electrical connection between the control signal connecting piece and the control signal interface 333. This reduces interference caused by another circuit to the control signal, and improves reliability of the motor controller 3.

In this application, the isolation belt 332 is arranged in the middle of the circuit board 33, so that utilization of the circuit board 33 can be improved, and signal interference between the power supply circuit component mounting region 33c and the control circuit component mounting region 33d that are arranged on one side of the isolation belt 332 and the plurality of power transistor signal terminal connecting regions 330 that are arranged on the other side can be reduced.

In an embodiment, the circuit board 33 includes a plurality of fastening holes 331, and each fastening hole 331 is configured to fasten the circuit board 33. Refer to FIG. 12 and FIG. 13. The plurality of fastening holes 331 are provided at edges of the circuit board 33.

In the first direction X, the plurality of fastening holes 331 separately run through the circuit board 33. The plurality of fastening holes 331 are configured to cooperate with the plurality of supporting columns 3010, so that the circuit board 33 is fastened to the integrated housing 301 by using the supporting columns.

In the second direction Y, a spacing between two adjacent fastening holes 331 is greater than a spacing between two adjacent power transistor signal terminal connecting regions 330, so that the supporting columns 3010 avoid the power transistor signal terminals 323 of the power modules 32. This avoids affecting an electrical connection between the power transistor signal terminals 323 and the circuit board 33, and improves the reliability of the motor controller 3.

In the third direction Z, a spacing between two adjacent fastening holes 331 is greater than a width of the isolation belt 332, to avoid affecting isolation effect of the isolation belt 332, thereby improving the reliability of the motor controller 3.

In an embodiment, with reference to FIG. 11, FIG. 12, and FIG. 13, each power transistor signal terminal connecting region 330 includes three rows of power transistor signal terminal interfaces 3300, and the three rows of power transistor signal terminal interfaces 3300 are configured to electrically connect to the power signal terminals 323 in the power module.

As shown in FIG. 12 and FIG. 13, each row of the power transistor signal terminal interfaces 3300 includes three power transistor signal terminal interfaces 3300. Each power transistor signal terminal interface 3300 is configured to electrically connect to a power transistor signal terminal of one power transistor, to implement signal transmission between the circuit board 33 and the power module.

In the first direction X, each power transistor signal terminal interface 3300 runs through the circuit board 33, to ensure that the power transistor signal terminal passes through the power transistor signal terminal interface 3300 in the first direction X and is electrically connected to the circuit board 33. In the second direction Y, the three power transistor signal terminal interfaces 3300 in each row of the power transistor signal terminal interfaces 3300 are arranged at intervals. In the third direction Z, the three rows of power transistor signal terminal interfaces 3300 in each power transistor signal terminal connecting region 330 are arranged at intervals.

In this application, a plurality of rows of power transistor signal terminal interfaces 3300 of the plurality of power modules 32 are spaced apart from each other, a plurality of rows of power transistor signal terminal interfaces 3300 of a same power module 32 are spaced apart from each other, and a plurality of power transistor signal terminal interfaces 3300 of a same row of power transistor signal terminal interfaces 3300 are spaced apart from each other, so that signal stability of power transistor signal terminal interfaces 3300 of each power transistor 320 in each power module 32 can be improved.

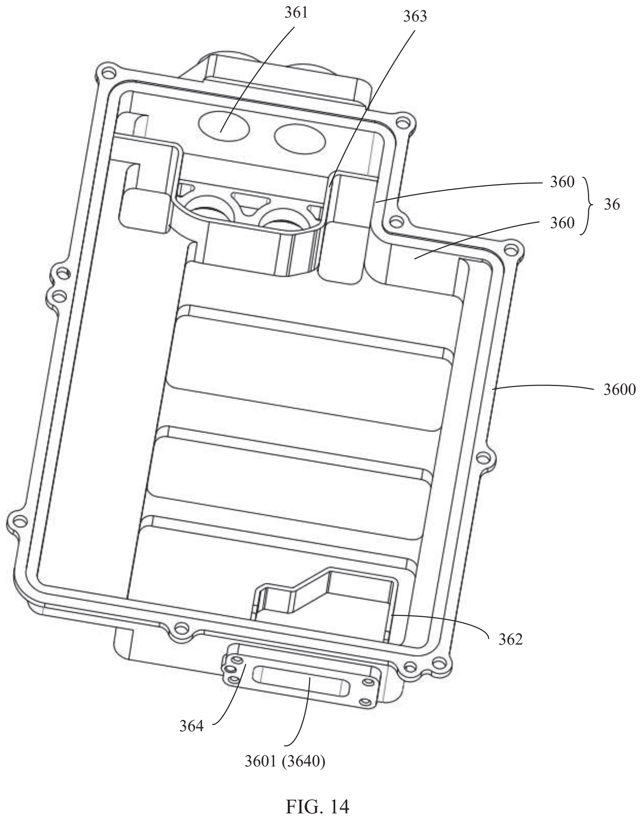

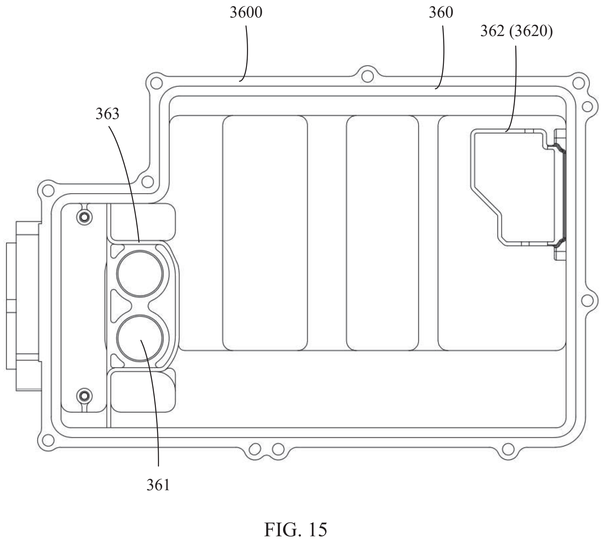

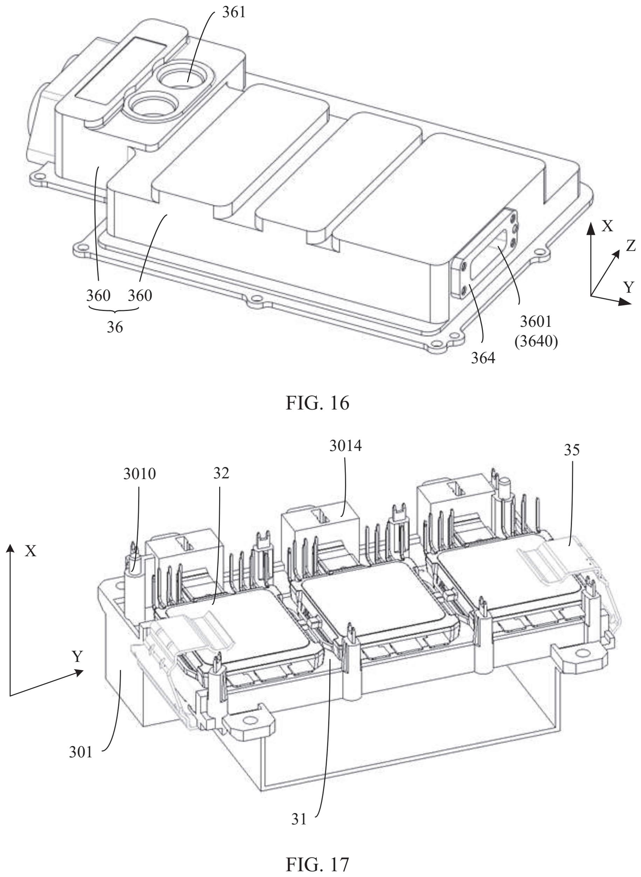

FIG. 14 is a diagram of an upper housing of a motor controller according to an embodiment of this application. FIG. 15 is a bottom view of FIG. 14. FIG. 16 is another diagram of an upper housing of a motor controller according to an embodiment of this application.

In an embodiment, the upper housing 36 includes a control signal shielding protrusion 362 and a control signal connecting piece mounting hole 3601. The control signal connecting piece mounting hole 3601 is configured to mount the control signal connecting piece 39. The control signal connecting piece 39 is configured to transmit a control signal to the control signal interface 333.

Refer to FIG. 3a, FIG. 14, FIG. 15, and FIG. 16. In the first direction X, an extension direction of the control signal shielding protrusion 362 faces the circuit board 33, and a projection of the control signal shielding protrusion 362 at least partially surrounds the control signal interface 333, to ensure that the control signal interface 333 is located in a shielding cavity formed by the control signal shielding protrusion 362 and the circuit board 33.

In the second direction Y, the projection of the control signal shielding protrusion 362 covers a projection of the control signal connecting piece mounting hole 3601, and the control signal connecting piece mounting hole 3601 runs through the upper housing 36. This can ensure that the control signal connecting piece 39 and the control signal connecting piece mounting hole 3601 are electrically connected to the control signal interface 333 located in the control signal shielding protrusion 362.

In this application, the control signal shielding protrusion 362 and the upper housing 36 are integrally formed. In the motor controller 3, a shielding structure for shielding the control signal interface 333 does not need to be independently disposed, so that assembly can be simplified and costs can be reduced.

In an embodiment, the circuit board 33 includes a metal wire 33a and a lower partition board 33b. Refer to FIG. 3, FIG. 3a, FIG. 12, and FIG. 15. The control signal interface 333 and the lower partition board 33b are located at an edge of the circuit board 33. In an embodiment, an area of a region enclosed by the metal wire 33a in the circuit board 33 is greater than an area of the control signal interface 333.

In an embodiment, the metal wire 33a is located on a side that is of the circuit board 33 and that faces the upper housing 36. As shown in FIG. 3a and FIG. 13, the upper housing 36 is stacked on the circuit board 33, and the control signal shielding protrusion 362 is electrically connected to the metal wire 33a of the circuit board 33. In the first direction X, the lower partition board 33b corresponds to the control signal shielding protrusion 362, and the lower partition board 33b is electrically connected to the metal wire 33a. The metal wire 33a, the lower partition board 33b, the control signal shielding protrusion 362, and the upper housing 36 connected to the control signal shielding protrusion 362 are combined to form the shielding cavity. This can improve shielding effect of shielding the control signal interface 333 and the control signal connecting piece 39, and improve the reliability of the motor controller 3.

In an embodiment, two ends of the control signal shielding protrusion 362 are respectively configured to be fastened to two sides of the control signal connecting piece mounting hole 3601. In the second direction Y, the projection of the control signal shielding protrusion 362 partially surrounds a projection of the control signal interface 333. In the third direction Z, two ends of the control signal shielding protrusion 362 are arranged on the two sides of the control signal connecting piece mounting holes 3601. The control signal shielding protrusion 362 covers the projection of the control signal connecting piece mounting hole 3601, and the control signal connecting piece 39 passes through the control signal connecting piece mounting hole 3601 and is electrically connected to the control signal interface 333 located in the control signal shielding protrusion 362.

In an embodiment, the control signal shielding protrusion 362 includes an annular protrusion 3620 and an avoidance opening. In the first direction X, a projection of the annular protrusion 3620 surrounds the projection of the control signal interface 333. When the annular protrusion 3620 is electrically connected to the circuit board 33, the annular protrusion 3620 completely covers the control signal interface 333. In the second direction Y, the avoidance opening runs through the annular protrusion 3620, a projection of the avoidance opening covers the projection of the control signal connecting piece mounting hole 3601, and the control signal connecting piece 39 passes through the control signal connecting piece mounting hole 3601 and the avoidance opening and is electrically connected to the control signal interface 333 located in the annular protrusion 3620. The control signal connecting piece 39 is electrically connected to the control signal interface 333, and the control signal connecting piece 39 is electrically connected to the control signal interface 333 through a transmission line.

In an embodiment, the annular protrusion 3620 is an enclosing board that is formed by a plurality of sub-boards and has openings at two ends. A shape of a projection of the enclosing board in the first direction X is a circle, a rectangle, a diamond, or another irregular shape.

In an embodiment, the upper housing 36 includes a plurality of sub-side boards 360, and the plurality of sub-side boards 360 extend to one side of the lower housing 37. The plurality of sub-side boards 360 are sequentially connected in pairs. A spacing between the control signal interface 333 and two connected sub-side boards 360 in the second direction Y is less than a spacing between the control signal interface 333 and another sub-side board 360.

In an embodiment, one of the two connected sub-side boards 360 includes the control signal connecting piece mounting hole 3601. With reference to FIG. 3, FIG. 3a, FIG. 12, FIG. 13, and FIG. 15, the spacing between the control signal interface 333 and two connected side boards is less than the spacing between the control signal interface 333 and another side board. One of the two connected sub-side boards includes the control signal connecting piece mounting hole 3601, and a spacing between the control signal shielding protrusion 362 and the sub-side board having the control signal connecting piece mounting hole 3601 is small, so that the control signal connecting piece is electrically connected to the control signal interface 333 by using the control signal connecting piece mounting hole and the control signal shielding protrusion.

In an embodiment, the upper housing 36 includes a plurality of flanges 3600, and the flanges 3600 are configured to be fastened to the lower housing 37.

In an embodiment, the upper housing 36 includes a direct current shielding protrusion 363 and the plurality of direct current connecting piece mounting holes 361. An extension direction of the direct current shielding protrusion 363 faces the circuit board 33 in the first direction X. The orientations of the openings of the plurality of direct current connecting piece mounting holes 361 include at least one of the first direction X and the second direction Y.

As shown in FIG. 14, the extension direction of the direct current shielding protrusion 363 is the same as the extension direction of the control signal shielding protrusion 362. Refer to FIG. 3, FIG. 3a, and FIG. 14. A projection of the direct current shielding protrusion 363 in the first direction X at least partially surrounds projections of the plurality of direct current connecting piece mounting holes 361. In this application, the upper housing 36 integrates the direct current shielding protrusion 363 and the control signal shielding protrusion 362, so that electrical disturbance can be reduced, and assembly difficulty of the motor controller 3 can be reduced.

As shown in FIG. 14, at least one of the plurality of direct current connecting piece mounting holes 361 is located on the sub-side board 360. An orientation of an opening of the at least one direct current connecting piece mounting hole 361 located on the sub-side board 360 is in the first direction X. As shown in FIG. 15, an orientation of an opening of at least one of the plurality of direct current connecting piece mounting holes 361 is in the second direction Y.

In an embodiment, the upper housing 36 includes a connecting board 364. Refer to FIG. 3a, FIG. 14, and FIG. 16. The connecting board 364 is fastened to a side that is of the sub-side board 360 on which the control signal connecting piece mounting hole 3601 is located and that is away from the control signal shielding protrusion 362 in the second direction. The connecting board 364 includes a positioning hole 3640. In the second direction Y, the positioning hole 3640 cooperates with the control signal connecting piece mounting hole 3601, to improve stability of the connection between the control signal connecting piece 39 and the upper housing 36.

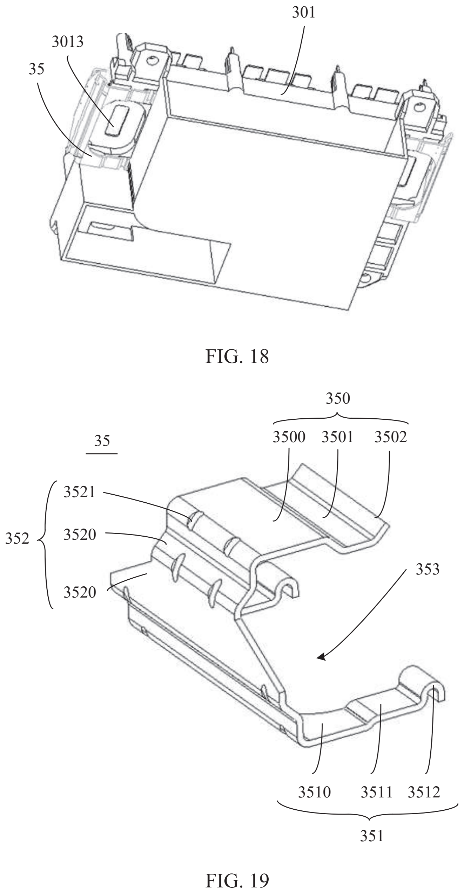

FIG. 17 is another diagram of a motor controller according to an embodiment of this application. FIG. 18 is a bottom view of FIG. 17. FIG. 19 is a diagram of a clamping piece in FIG. 17. In an embodiment, the motor controller 3 includes a clamping piece 35.

The integrated housing 301 includes the plurality of Hall magnetic cores 3014 arranged in the second direction Y and the two rows of supporting columns 3010. Each row of the supporting columns 3010 includes a plurality of supporting columns 3010 arranged at intervals in the second direction Y. The plurality of Hall magnetic cores 3014 are located on a side that is of one row of the supporting columns 3010 and that is away from the other row of the supporting columns 3010.

As shown in FIG. 17, the liquid cooling heat sink 31 is stacked on the integrated housing 301 in the first direction X. The plurality of power modules 32 are arranged on a surface of the liquid cooling heat sink 31 in the second direction Y. The liquid cooling heat sink 31 is located between the two rows of supporting columns 3010.

In an embodiment, in the first direction X, the clamping piece 35 includes two opposite ends, and the integrated housing 301 and the liquid cooling heat sink 31 are fastened between the two ends of the clamping piece 35.

In an embodiment, one end of the clamping piece 35 abuts against a surface that is of the power module 32 and that is away from the liquid cooling heat sink 31, and the other end of the clamping piece 35 abuts against a side that is of the integrated housing 301 and that is away from the liquid cooling heat sink 31, to fasten the liquid cooling heat sink 31 and the power module 32 to the integrated housing 301.

In this application, the clamping piece 35 fastens the liquid cooling heat sink 31 and the integrated housing 301 in the first direction X, so that structural stability of the motor controller can be improved, and an assembly process of the motor controller 3 can be simplified. In addition, the liquid cooling heat sink 31 can be conveniently disassembled for maintenance.

Refer to FIG. 18 and FIG. 19. The integrated housing 301 includes two coolant through holes 3013. The clamping piece 35 includes an avoidance opening 353, and the avoidance opening 353 is configured to avoid the coolant through hole 3013. As shown in FIG. 18, the clamping piece 35 is fastened to the liquid cooling heat sink 31 and the integrated housing 301, and the avoidance opening 353 may avoid interference caused by the clamping piece 35 to the coolant through hole 3013.

In an embodiment, the motor controller 3 includes two clamping pieces 35. As shown in FIG. 17, the two clamping pieces 35 respectively cooperate with two power modules 32 that are respectively located at a head end and a tail end. The head end is a first one in an arrangement direction of the plurality of power modules 32, and the tail end is a last one in the arrangement direction of the plurality of power modules 32.

In an embodiment, the clamping piece 35 includes a body part 352, an upper clamping part 350, and a lower clamping part 351. The upper clamping part 350 and the lower clamping part 351 are connected to two ends of the body part 352. In the first direction X, the upper clamping part 350 and the lower clamping part 351 are located on a same side of the body part 352. The upper clamping part 350 is configured to clamp with and fasten to a side that is of the power module 32 located at the head end or the tail end and that is away from the liquid cooling heat sink 31. The lower clamping part 351 is configured to clamp with and fasten to a side that is of the integrated housing 301 and that is away from the liquid cooling heat sink 31. The upper clamping part 350 includes an upper connecting board 3500, an upper clamping board 3501, and a guide board 3502. The upper connecting board 3500 connects the upper clamping board 3501 to the body part 352. The guide board 3502 is connected to a side that is of the upper clamping board 3501 and that is away from the upper connecting board 3500. The guide board 3502 extends to a side that is away from the lower clamping part 351. When the clamping piece 35 fastens the power module 32 located at the head end or the tail end to the integrated housing 301, the guide board 3502 included in the clamping piece 35 can play a guide role.

A spacing between the upper connecting board 3500 and the lower clamping part 351 in the first direction X is greater than an interval between the upper clamping board 3501 and the lower clamping part 351, and a spacing between the guide board 3502 and the lower clamping part 351 is also greater than the interval between the upper clamping board 3501 and the lower clamping part 351. It may be understood that the upper connecting board 3500, the upper clamping board 3501, and the guide board 3502 are sequentially connected, the upper connecting board 3500, the upper clamping board 3501, and the guide board 3502 are approximately U-shaped, and a U-shaped opening is away from the lower clamping part 351. The interval between the upper clamping board 3501 and the lower clamping part 351 in the first direction X is less than a spacing between the power module 32, the liquid cooling heat sink 31, and the integrated housing 301 away from the liquid cooling heat sink 31, to ensure that the upper clamping board 3501 and the lower clamping part 351 can stably fasten the liquid cooling heat sink 31 and the power module 32 to the integrated housing 301.

The lower clamping part 351 includes a lower connecting board 3510, a lower clamping board 3511, and a buckle 3512. The lower connecting board 3510, the lower clamping board 3511, and the buckle 3512 are sequentially connected. An interval between the upper clamping board 3501 and the lower clamping board 3511 in the first direction X is less than the spacing between the power module 32, the liquid cooling heat sink 31, and the integrated housing 301 away from the liquid cooling heat sink 31, to ensure that the upper clamping board 3501 and the lower clamping board 3511 can stably fasten the liquid cooling heat sink 31 and the power module 32 to the integrated housing 301. The buckle 3512 can be clamped to an edge of a side that is of the integrated housing 301 and that is away from the power module 32, to improve stability of the connection of the power module 32 and the liquid cooling heat sink 31 to the integrated housing 301.

In an embodiment, the avoidance opening 353 is formed on one lower clamping part 351, to divide the lower clamping part 351 into two parts. Alternatively, each clamping piece 35 includes two same lower clamping parts 351, and a gap between the two lower clamping parts 351 is the avoidance opening 353.

The body part 352 includes a plurality of connecting sections 3520, and an included angle between two adjacent connecting sections 3520 is greater than or equal to 90 degrees, so that the body part 352 is approximately U-shaped. Each connecting section 3520 includes at least one reinforcing rib, and the reinforcing rib is configured to improve strength of the body part. In addition, to reduce a weight of the clamping piece 35, the body part 352 includes a plurality of weight reduction holes 3521, and the weight reduction holes 3521 run through the body part 352.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An integrated component used in a motor controller, wherein the integrated component comprises an integrated housing and a capacitor core, the integrated housing is configured to accommodate the capacitor core, the integrated housing comprises a first surface and a second surface that are opposite to each other in a first direction, the first surface comprises two rows of fastening columns and two rows of supporting columns, each row of the fastening columns comprises a plurality of fastening columns, and each row of the supporting columns comprises a plurality of supporting columns, wherein
in a second direction, the plurality of fastening columns in each row of the fastening columns are arranged at intervals, and the plurality of supporting columns in each row of the supporting columns are arranged at intervals; and
in a third direction, the two rows of supporting columns are arranged at an interval, and the two rows of fastening columns are arranged between the two rows of supporting columns at an interval.

2. The integrated component according to claim 1, wherein the first surface comprises a row of Hall magnetic cores, and the row of Hall magnetic cores comprises a plurality of Hall magnetic cores, wherein
in the second direction, the plurality of Hall magnetic cores are arranged at intervals, and each Hall magnetic core is arranged between two adjacent supporting columns.

3. The integrated component according to claim 2, wherein the first surface comprises a plurality of mounting grooves, the plurality of mounting grooves are arranged at intervals in the second direction, and each mounting groove is configured to mount one Hall magnetic core.

4. The integrated component according to claim 3, wherein the integrated component comprises a plurality of copper bar connecting pieces, each copper bar connecting piece is generally configured to electrically connect to one power module, each Hall magnetic core comprises a magnetic core through hole, and each magnetic core through hole is configured to allow one copper bar connecting piece to pass through in the third direction.

5. The integrated component according to any one of claims 1 to 4, wherein the second surface comprises a filter cavity, the filter cavity is configured to accommodate a filter, and an orientation of an opening of the filter cavity is in the first direction.

6. A motor controller, wherein the motor controller comprises a liquid cooling heat sink, a plurality of power modules, and the integrated component according to any one of claims 1 to 5, each power module comprises at least one power transistor, each power transistor is electrically connected to a capacitor core, and an integrated housing comprises two coolant through holes, wherein
in a first direction, the two coolant through holes separately run through the integrated housing; and
in a second direction, the two coolant through holes are arranged at an interval.

7. The motor controller according to claim 6, wherein in the first direction, the liquid cooling heat sink and the integrated housing are arranged in a stacked manner;
in the second direction, a spacing between the two coolant through holes is less than a length of the liquid cooling heat sink; and
in a third direction, a diameter of each coolant through hole is less than a width of the liquid cooling heat sink.

8. The motor controller according to claim 7, wherein each power module comprises a plurality of direct current power input terminals, each direct current power input terminal is configured to electrically connect to one power transistor and the capacitor core, and the plurality of direct current power input terminals are sequentially arranged along one side of the liquid cooling heat sink.

9. The motor controller according to claim 7, wherein the motor controller comprises a circuit board, the circuit board is configured to control operating of the power transistors in the plurality of power modules, and the circuit board comprises an isolation belt, a plurality of power transistor signal terminal connecting regions, a power supply circuit component mounting region, a control circuit component mounting region, and a control signal interface mounting region, wherein
in the first direction, the plurality of power modules are separately arranged in a stacked manner with the circuit board;
in the second direction, the power supply circuit component mounting region, the control circuit component, and the control signal interface mounting region are sequentially distributed at intervals, and the plurality of power transistor signal terminal connecting regions are sequentially distributed at intervals; and
in the third direction, the plurality of power transistor signal terminal connecting regions are distributed on one side of the isolation belt, and the power supply circuit component mounting region, the control circuit component, and the control signal interface mounting region are distributed on the other side of the isolation belt.

10. The motor controller according to claim 9, wherein the motor controller comprises an upper housing and a lower housing, the liquid cooling heat sink and the integrated component are arranged in a stacked manner between the upper housing and the lower housing in the first direction, the lower housing comprises two coolant channels, and the two coolant channels are respectively configured to connect to the two coolant through holes.

11. The motor controller according to claim 10, wherein the lower housing comprises two coolant openings, each coolant opening is configured to connect to one coolant through hole, and an orientation of each coolant opening is in the first direction, wherein
in the second direction, a spacing between the two coolant openings is less than the length of the liquid cooling heat sink; and
in the third direction, a diameter of each coolant opening is less than the width of the liquid cooling heat sink.

12. The motor controller according to claim 11, wherein the lower housing comprises two coolant interfaces, each coolant interface is configured to connect to one coolant opening through one coolant channel, the orientation of each coolant opening is in the third direction, and the spacing between the two coolant openings in the second direction is less than the length of the liquid cooling heat sink.

13. The motor controller according to claim 10, wherein the upper housing comprises a control signal connecting piece mounting hole and a plurality of direct current connecting piece mounting holes, wherein
the control signal connecting piece mounting hole is configured to mount a control signal connecting piece, the control signal connecting piece is configured to receive a control signal, and an orientation of an opening of the control signal connecting piece mounting hole is in the second direction; and
the plurality of direct current connecting piece mounting holes are respectively configured to mount a plurality of direct current connecting pieces, orientations of openings of the plurality of direct current connecting piece mounting holes comprise at least one of the first direction or the second direction, and the plurality of direct current connecting pieces are separately configured to transmit a direct current.

14. A powertrain, wherein the powertrain comprises a motor and the motor controller according to any one of claims 6 to 13, and the motor controller is configured to drive the motor.
